# EUROPEAN PATENT APPLICATION

(11) **EP 2 322 690 A2**
(43) Date of publication of application: **18.05.2011**
(21) Application number: 10188627.3
(22) Date of filing: 22.10.2010
(51) Int. Cl.: C23C 16/18, C23C 30/00, C07F 7/00

(54) **Methods for deposition of group 4 metal containing films**

(30) Priority: 23.10.2009 US 254253 P; 14.10.2010 US 904461
(71) Applicant: AIR PRODUCTS AND CHEMICALS, INC., Allentown, PA 18195-1501 (US)
(72) Inventor: Ivanov, Sergei Vladimirovich, Schnecksville, PA 18078 (US); Lei, Xinjian, Vista,, CA 92081 (US); Cheng, Hansong, 117543 Singapore (SG); Spence, Daniel P., Carlsbad, CA 92008 (US); Kim, Moo-Sung, 463-758, Sungnam, Gyunggi-Do (KR)
(74) Representative: Stones, James Alexander

(57) **Abstract**

Metal-containing films may be formed by atomic layer deposition using precursors of the formula: 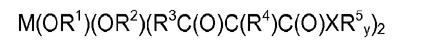 wherein M is Group 4 metals; wherein R¹ and R² are independently selected from the group consisting of linear or branched C₁₋₁₀ alkyls and C₆₋₁₂ aryls; R³ is selected from the group consisting of linear or branched C₁₋₁₀ alkyls and C₆₋₁₂ aryls, and is preferably C₁₋₃ alkyl; R⁴ is selected from the group consisting of hydrogen, C₁₋₁₀ alkyls, and C₆₋₁₂ aryls, and is preferably hydrogen; R⁵ is selected from the group consisting of linear or branched C₁₋₁₀ alkyls and C₆₋₁₂ aryls, and is preferably a methyl or ethyl group; and X = O or N, wherein when X = O, y = 1 and R¹, 2 and ⁵ are the same, and when X = N, y = 2 and each R⁵ can be the same or different.

## Description

The present invention relates to methods for forming Group 4 metal containing films such as, but not limited to, titanium oxide, doped titanium oxide, zirconium oxide, doped zirconium oxide, strontium titanate and barium strontium titanate by atomic layer deposition (ALD), that may be used, for example, as a gate dielectric or capacitor dielectric film in a semiconductor device.

With each generation of metal oxide semiconductor (MOS) integrated circuit (IC), the device dimensions have been continuously scaled down to provide for high-density and high-performance such as high speed and low power consumption requirements. Unfortunately, field effect semiconductor devices produce an output signal that is proportional to the width of the channel, such that scaling reduces their output. This effect has generally been compensated for by decreasing the thickness of the gate dielectric, thus bringing the gate in closer proximity to the channel and enhancing the field effect which thereby increasing the drive current. Therefore, it has become increasingly important to provide extremely thin reliable and low-defect gate dielectrics for improving device performance.

For decades, a thermal silicon oxide, SiO₂ has been mainly used as a gate dielectric because it is stable with the underlying silicon substrate and its fabrication process is relatively simple. However, because the silicon oxide gate dielectric has a relatively low dielectric constant (k), 3.9, further scaling down of silicon oxide gate dielectric thickness has become more and more difficult, especially due to gate-to-channel leakage current through the thin silicon oxide gate dielectric.

This leads to consideration of alternative dielectric materials that can be formed in a thicker layer than silicon oxide but still produce the same or better device performance. This performance can be expressed as "equivalent oxide thickness" (or EOT). Although the alternative dielectric material layer may be thicker than a comparative silicon oxide layer, it has the equivalent effect of a much thinner layer of silicon oxide layer.

To this end, high-k metal oxide materials have been proposed as the alternative dielectric materials for gate or capacitor dielectrics. Group 4-containing precursors may also be used by themselves or combined with other metal-containing precursors, such as, for example, Pb(Zr,Ti)O₃ or (Ba,Si)(Zr,Ti)O₃, to make high dielectric constant and/or ferroelectric oxide thin films. Because the dielectric constant of metal oxide materials can be made greater than that of the silicon oxide, a thicker metal oxide layer having a similar EOT can be deposited. As a result, the semiconductor industry requires Group 4 precursors, such as, for example, titanium-containing, zirconium-containing, and hafnium-containing precursors and combinations thereof, to be able to deposit metal-containing films such as, but not limited to, oxide, nitride, silicate or combinations thereof on substrates such as metal nitride or silicon.

Unfortunately, the use of high-k metal oxide materials presents several problems when using traditional substrate materials, such as silicon. The silicon can react with the high-k metal oxide or be oxidized during deposition of the high-k metal oxide or subsequent thermal processes, thereby forming an interface layer of silicon oxide. This increases the equivalent oxide thickness, thereby degrading device performance. Further, an interface trap density between the high-k metal oxide layer and the silicon substrate is increased. Thus, the channel mobility of the carriers is reduced. This reduces the on/off current ratio of the MOS transistor, thereby degrading its switching characteristics. Also, the high-k metal oxide layer such as a hafnium oxide (HfO₂) layer or a zirconium oxide (ZrO₂) layer has a relatively low crystallization temperature and is thermally unstable. Thus, the metal oxide layer can be easily crystallized during a subsequent thermal annealing process for activating the impurities injected into source/drain regions. This can form grain boundaries in the metal oxide layer through which current can pass. As the surface roughness of the metal oxide layer increases, the leakage current characteristics may deteriorate. Further, the crystallization of the high-k metal oxide layer undesirably affects a subsequent alignment process due to irregular reflection of the light on an alignment key having the rough surface.

A number of various delivery systems have been developed for delivery of precursors to CVD or ALD reactors. For example, in direct liquid injection (DLI) method a liquid precursor or a solution of a precursor in a solvent is delivered to a heated vaporization system, whereby the liquid composition is transferred from the liquid phase to the gas phase. Advanced liquid metering of the precursor to the vaporizer provides accurate, stable control of precursor delivery rate. Another method, which is already widely used in semiconductor industry for delivery of metal organic precursors, is based on conventional bubbler technology, where inert gas is bubbled through a neat liquid or a molten precursor at elevated temperature. Typically precursors have low vapor pressure and have to be heated to 100-200°C to deliver enough precursor vapors to the deposition reactor by the bubbling method. Solid precursors delivered from their molten phase may plug the lines during multiple cooling/heating cycles. It is desired that precursors are liquids or solids with melting point significantly lower than the bubbler temperature. Products of thermal decomposition may also plug delivery lines and affect the delivery rate of precursors. Extended periods of time at the bubbler temperatures may also cause thermal decomposition of the precursors. The precursors may also react with traces of moisture and oxygen introduced to the bubbler during multiple deposition cycles.

A number of Group 4 complexes containing alkoxy, diketonate, ketoesterate, cyclopentadienyl ligands have been proposed for CVD of metal oxide films.

Prior art in the field of the invention includes; US 6,603,033; Chem. Vap. Deposition, 9, p. 295 (2003); J. of Less Common Metals, 3, p. 253 (1961); J. Am. Chem. Soc. 79, pp.4344-4348 (1957); JP 2007/197804 A; JP 10-114781 A; WO 1984/003042 A1; JP 28-22946 B2; US 6,562,990 B; US 6,117,487, WO 96/40690; US 2010/0018439 A; Journal of the Chemical Society A: Inorganic, Physical, and Theoretical Chemistry, 904-907 (1970); Chemical Communications, 10, pp.1610-1611 (2004); Journal of Materials Chemistry, 14, pp. 3231-3238 (2004); Chemical Vapor Deposition 12, 172-180 (2006); US 2007/0248754 A1, US Serial No. 11/945678 filed on November 27, 2007, Applicants' co-pending application U.S. Serial No. 12/266,806 which was filed on November 11, 2008; and Applicants' co-pending application or U.S. Serial No. 12/245,196 which was filed on October 3, 2008; Gornshtein, F., M. Kapon, M. Botoshansky and M. S. Eisen (2007). "Titanium and Zirconium Complexes for Polymerization of Propylene and Cyclic Esters." Organometallics 26(3): pp. 497-507; and Bae, B.-J., K. Lee, W. S. Seo, M. A. Miah, K.-C. Kim and J. T. Park (2004). "Preparation of anatase TiO2 thin films with (OPri)2Ti(CH3COCHCONEt2)2 precursor by MOCVD." Bull. Korean Chem. Soc. 25(11): pp. 1661-1666.

As previously discussed, the Group 4 precursors in the prior art are mostly solid and have relatively low vapor pressure (e.g., 0.5 torr (67 Pa) or below). Of the few Group 4 precursors that are in liquid form and that are reported in the prior art, these precursors are apparently not thermally stable at temperatures greater than 150°C, thus causing delivery or process issues during semiconductor manufacturing which can include, but are not limited to, clogging of the delivery lines between the source container and reactor and particles deposited on the wafers. The precursors also have low ALD operating thermal window and/or low ALD growth rate/cycle.

Accordingly, there is a need to develop Group 4 precursors, preferably Group 4 precursors that are liquid at room temperature and pressure, e.g. about 20°C and about 1 bar, which are capable to deposit thin films by atomic layer deposition and which exhibit at least one of the following properties: lower molecular weight (e.g., 500 mass units ("m.u.") or below), lower melting point (e.g., 60°C or below), high vapor pressure (e.g., 0.5 torr (67 Pa) or greater) also high ALD thermal window (e.g., 300 °C and above), and ALD growth rate > 0.3 A/cycle (0.03 nm/cycle).

The present invention is related to methods for forming metal-containing films such as, but not limited to, titanium oxide, doped titanium oxide, zirconium oxide, doped zirconium oxide, strontium titanate and barium strontium titanate by atomic layer deposition using precursors represented by the formula: 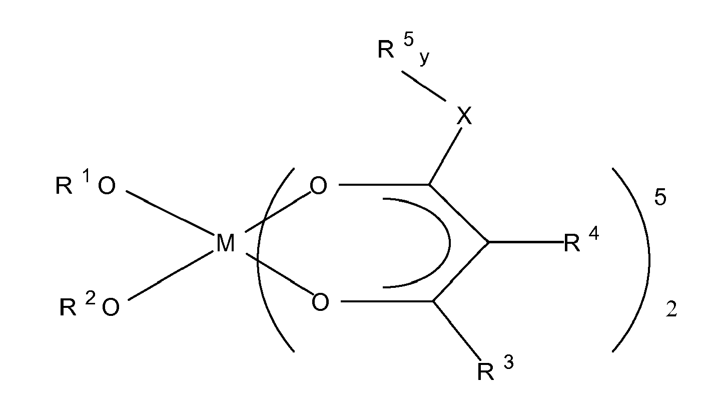 wherein M is a Group 4 metal selected from the group consisting of Ti, Zr, and Hf; wherein R¹ and R² are independently selected from the group consisting of linear or branched C₁₋₁₀ alkyls and C₆₋₁₂ aryls, and are preferably selected from C₁₋₄ alkyls; R³ is selected from the group consisting of linear or branched C₁₋₁₀ alkyls and C₆₋₁₂ aryls, and is preferably C₁₋₃ linear alkyl or C₃₋₆ "bulky" alkyl; R⁴ is selected from the group consisting of hydrogen, C₁₋₁₀ alkyls, and C₆₋₁₂ aryls, and is preferably hydrogen; R⁵ is selected from the group consisting of linear or branched C₁₋₁₀ alkyls and C₆₋₁₂ aryls, and is preferably a methyl or ethyl group; and X = O or N, wherein when X = O, y = 1 and R¹, 2 and ⁵ are the same, and when X = N, y = 2 and each R⁵ can be the same or different.

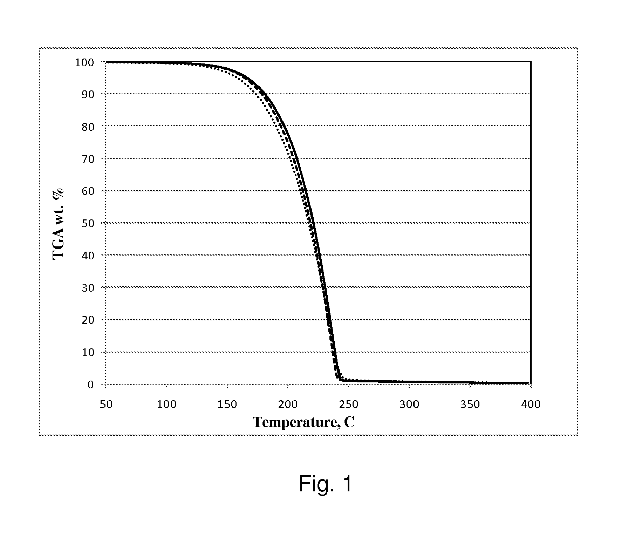

Figure 1 is a graph of thermogravimetric analysis (TGA) for bis(iso-propoxy)bis(methyl 4,4-dimethyl-3-oxopentanoato)titanium (dotted line), bis(ethoxy)bis(methyl 4,4-dimethyl-3-oxopentanoato)titanium (dashed line), and bis(n-propoxy)bis(methyl 4,4-dimethyl-3-oxopentanoato)titanium (solid line), indicating all precursors are volatile and have low residue.
Figure 2 is a graph of thickness vs temperature for ALD of TiO₂ using bis(iso-propoxy)bis(N,N-dimethylacetoacetamido)titanium and ozone.
Figure 3 is the temperature dependence of thermal ALD of depositing titanium oxide film using 100 ALD cycles of ozone and bis(methoxy)bis(methyl 4,4-dimethyl-3-oxopentanoato)titanium, indicating that ALD thermal window for this precursor is up to - 370 °C.
Figure 4 is the temperature dependence of thermal ALD of depositing titanium oxide film using 100 ALD cycles of ozone and bis(ethoxy)bis(ethyl 4,4-dimethyl-3-oxopentanoato)titanium, indicating that ALD thermal window for this precursor is at least up to - 375 °C.
Figure 5 is the dependence of titanium oxide thickness on the number of ALD cycles using ozone and bis(ethoxy)bis(ethyl 4,4-dimethyl-3-oxopentanoato)titanium with two different dosing time of the titanium precursor, confirming true self-limiting ALD process at - 375 °C.
Figure 6 is the Transmission Electron Microscope (TEM) of the deposited TiO₂ film on a patterned substrate employing bis(ethoxy)bis(ethy 4,4-dimethyl-3-oxopentanoato)titanium as liquid titanium precursor, demonstrating excellent step coverage (>90 %) from the top to the bottom of the patterned substrate.

The present invention is related to methods for forming metal-containing films such as, but not limited to, titanium oxide, doped titanium oxide, zirconium oxide, doped zirconium oxide, doped lanthanide oxide, strontium titanate and barium strontium titanate by: (a) cyclic chemical vapor deposition; or, (b) atomic layer deposition using precursors represented by the formula: M(OR¹)(OR²)(R³C(O)C(R⁴)C(O)XR⁵_{y})₂; also illustrated in 2 dimensions as: 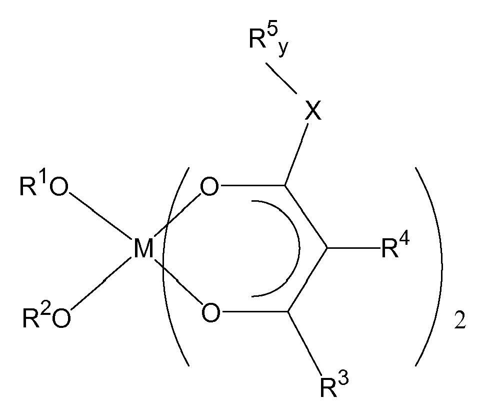 wherein M is a Group 4 metal selected from the group consisting of: Ti, Zr, and Hf; wherein R¹ and R² are independently selected from the group consisting of linear or branched C₁₋₁₀ alkyls and C₆₋₁₂ aryls, and are preferably selected from C₁₋₄ alkyls; R³ is selected from the group consisting of linear or branched C₁₋₁₀ alkyls and C₆₋₁₂ aryls, and is preferably C₃₋₆ alkyl; R⁴ is selected from the group consisting of hydrogen, C₁₋₁₀ alkyls, and C₆₋₁₂ aryls, and is preferably hydrogen; R⁵ is selected from the group consisting of linear or branched C₁₋₁₀ alkyls and C₆₋₁₂ aryls, and is preferably a methyl or ethyl group; and X = O or N, wherein when X= O, y = 1 and R^{1,2 and 5} are the same, and when X = N, y = 2 and each R⁵ can be the same or different.

More specifically the family of liquid Group 4 precursors is represented by the following two embodiments, Formula I and II: 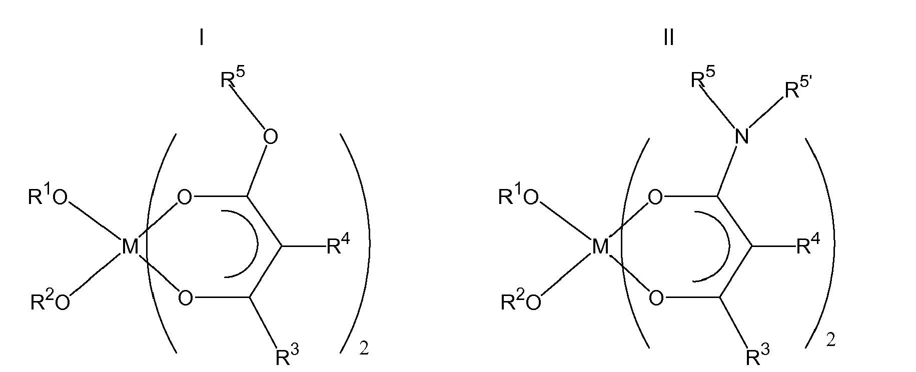 wherein M is a Group 4 metal including Ti, Zr, and Hf; wherein R¹ and R² are independently selected from the group consisting of linear or branched C₁₋₁₀ alkyls and C₆₋₁₂ aryls; R³ is selected from the group consisting of linear or branched C₁₋₁₀ alkyls and C₆₋₁₂ aryls, and is preferably branched C₃₋₆ alkyl for Formula I and linear C₁₋₃ alkyl for Formula II; R⁴ is selected from the group consisting of hydrogen, C₁₋₁₀ alkyls, and C₆₋₁₂ aryls, and is preferably hydrogen; R^{5-5'} are independently selected from the group consisting of linear or branched C₁₋₁₀ alkyls and C₆₋₁₂ aryls, and are preferably a methyl or ethyl group. In Formula I, R^{1,2 and 5} are the same.

In one particular embodiment, M is titanium; R¹ and R² are same and selected from the group comprising methyl, ethyl or n-propyl group; R³ comprises a branched C₃₋₆ alkyl group, preferably tert-butyl or tert-amyl; R⁴ comprises hydrogen; and R⁵ is same as R¹⁻² and selected from the group comprising methyl, ethyl or n-propyl group. Exemplary precursors are illustrated below, Formula III and IV:

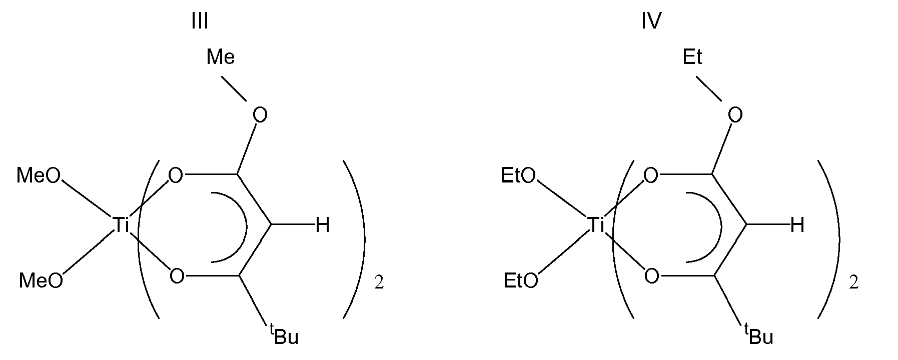

In another particular embodiment, M is Zr or Hf; R¹⁻² comprises an iso-propyl, tert-butyl, sec-butyl, iso-butyl, tert-amyl; R³ comprises a bulky alkyl group comprising from 3 to 6 carbon atoms; R⁴ comprises hydrogen; and R⁵ comprises a methyl, ethyl or n-propyl group.

Exemplary precursors are illustrated below in Formulae V - VI:

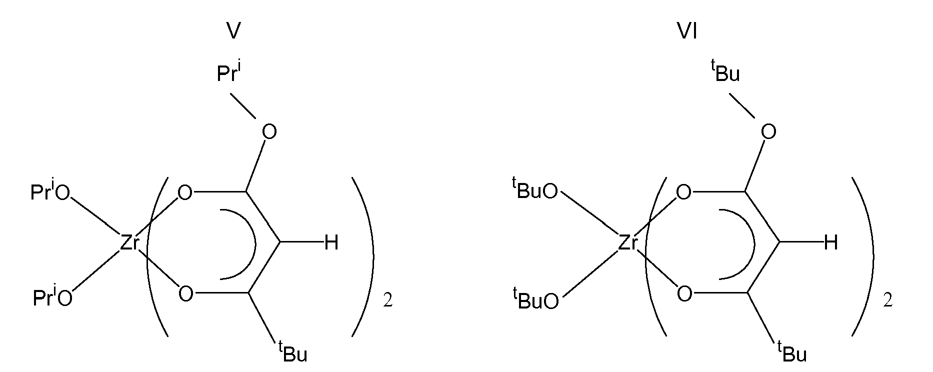

One useful feature of the precursors of Formula I is having R⁵ the same as R¹⁻² so that they have only common alkoxy groups, which prevents the formation of other metal precursor complexes at higher temperature by exchange of alkoxy groups between the adjacent bonding sites, thus providing good thermal and compositional stability. Good thermal and compositional stability of the precursors is important to ensure consistent precursor delivery to a vapor deposition chamber and consistent vapor deposition parameters. For example, no changes were observed in ¹H NMR spectra and in TGA residue of bis(methoxy)bis(methyl 4,4-dimethyl-3-oxopentanoato)titanium before and after heating for one hour at 200°C, indicating no changes in its composition after thermal treatment, and thus, very good thermal stability of this precursor. In contrast, multiple alkoxy group exchange processes were observed by ¹H NMR and GC-MS analyses for precursors of Formula I having different R⁵ and R¹⁻² when heated for one hour at 200°C, as shown by exemplary Reactions A and B. Heating such complexes in a container may result in a mixture of complexes having different composition and volatilities.

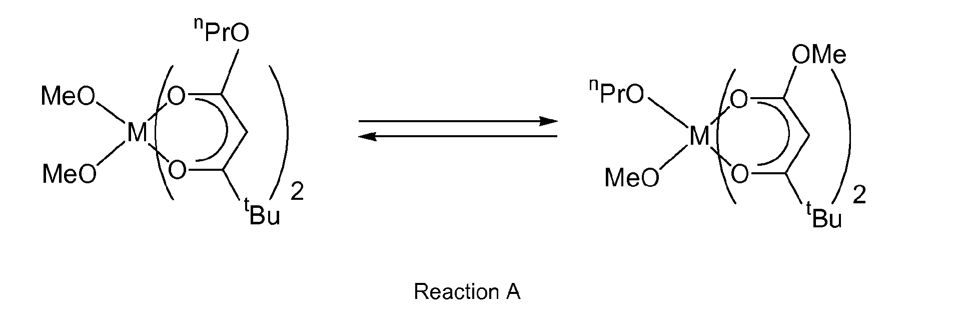

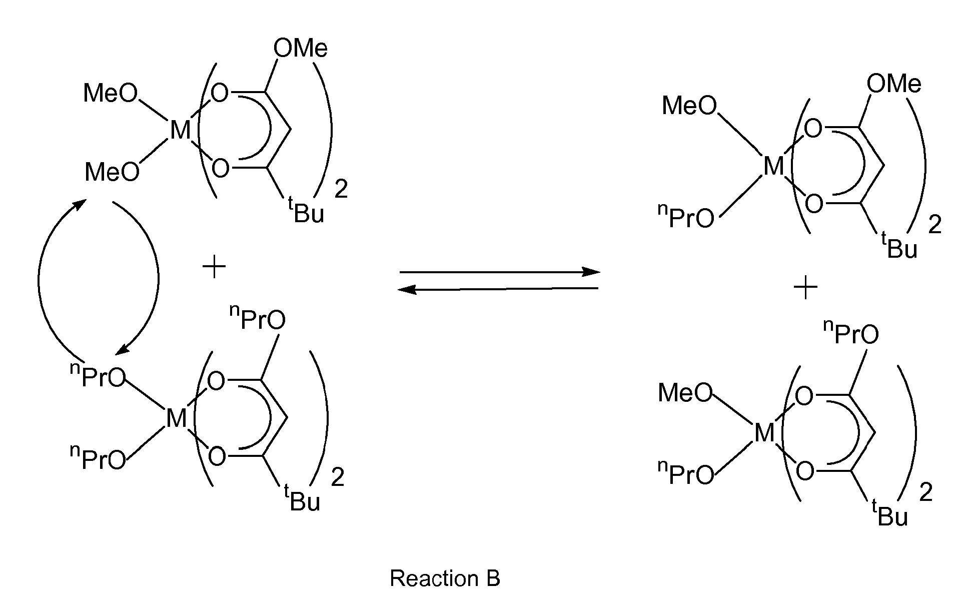

The term "alkyl" as used herein includes linear, branched, or cyclic alkyl groups, comprising from 1 to 10 carbon atoms, preferably from 1 to 6 carbon atoms, more preferably from 4 to 6 carbons atoms, more preferably from 3 to 5 carbon atoms, most preferably from 1 to 3 carbon atoms, or variations of the foregoing ranges. Exemplary alkyl groups include, but are not limited to, methyl, ethyl, n-propyl, iso-propyl, n-butyl, isobutyl, sec-butyl, tert-butyl, tert-amyl, n-pentyl, n-hexyl, cyclopentyl, and cyclohexyl. The term "alkyl" applies also to alkyl moieties contained in other groups, such as; haloalkyl, alkylaryl, or arylalkyl.

The term "bulky" as used herein describes alkyl groups that are more sterically hindered compared to linear alkyl groups having the same number of carbon atoms and may include, for example, branched alkyl groups, cyclic alkyl groups, or alkyl groups having one or more side changes and/or substituents.

The term "aryl" as used herein comprises 6 to 12 member carbon rings having aromatic character. Exemplary aryl groups include phenyl and naphthyl groups.

The term "alkyl-substituted aryl" applies to aryl moieties that are substituted with alkyl. Exemplary alkyl-substituted aryl groups include tolyl and xylyl groups.

The term "halo" and "halogen" include fluorine, chlorine, bromine, or iodine. In certain embodiments, some of the groups discussed herein may be substituted with one or more other elements such as, for example, a halogen atom or other heteroatoms, such as; O, N, Si, or S.

In certain embodiments, R³ and R⁵ in the β-diketoesterate ligand of Formula I are different alkyl groups. Examples of these β-diketoester ligands include, but are not limited to; methyl 4,4-dimethyl-3-oxopentanoate (MDOP) and ethyl 4,4-dimethyl-3-oxopentanoate (EDOP).

In other embodiments, R³ and R⁵ in the β-diketoester ligand are the same alkyl groups. Examples of these β-diketoester ligands include, but are not limited to; methyl acetoacetate and ethyl acetoacetate.

In one embodiment of the method disclosed herein, the Group 4 metal-containing film is formed using cyclic chemical vapor deposition or atomic layer deposition method that comprises the steps of: (a) introducing a Group 4 metal-containing precursor in a vapor state into a reaction chamber and chemisorbing the metal-containing precursor onto a substrate which is heated; (b) purging away the unreacted Group 4 metal-containing precursor; (c) introducing an oxygen source onto the heated substrate to react with the sorbed Group 4 metal-containing precursor; and (d) purging away the unreacted oxygen source and reaction by-products. The above steps define one cycle for the method described herein; and the cycle can be repeated until a desired thickness of a metal-containing film is obtained. The thickness of the film deposited during one atomic layer deposition cycle, herein referred as ALD growth rate, depends on the type of ALD precursor, the surface where ALD reactions occur, and deposition temperature.

In one embodiment of the method, ALD growth rate is > 0.3 Å/cycle (0.03 nm/cycle). Table 1 summarizes atomic layer deposition of titanium oxide films using a commercially available titanium diketonate complex; bis(isopropoxy)bis(2,2,6,6-tetramethyl-3,5-heptanedionato)titanium and precursors of this invention: bis(methoxy)bis(methyl 4,4-dimethyl-3-oxopentanoato)titanium, bis(ethoxy)bis(ethyl 4,4-dimethyl-3-oxopentanoato)titanium, bis(iso-propoxy)bis(N,N-Dimethylacetoacetamido)titanium, and bis(n-propoxy)bis(methyl 4,4-dimethyl-3-oxopentanoato)titanium. Unexpectedly, precursors of this invention containing ester or amide groups in the diketonate structure provide higher atomic layer deposition growth rates, than the similar titanium diketonate complex containing only alkyl groups.

**Table 1**

| Precursor | 1 | 2 | 3 | 4 | 5 |
|---|---|---|---|---|---|
| Melting Point, °C | >190 | 80 | < 25 | 51 | < 25 |
| Bubbler Temp, °C | 130 | 150 | 130 | 120 | 150 |
| State at Bubbler Temp | Solid | Liquid | Liquid | Liquid | Liquid |
| ALD/CVD Transition Temperature °C | 375 | 320 | 370 | 370 | 375 |
| Growth Rate Å/cycle (nm/cycle) | | | | | |
| at 320 °C, 3sec Pulse | 0.15 (0.015) | 0.32 (0.032) | | 0.36^{a} (0.036) | |
| at 320 °C, 6sec Pulse | 0.18 (0.018) | 0.38 (0.038) | | 0.37^{b} (0.037) | |
| at 350 °C, 4sec Pulse | | | 0.42 (0.042) | 0.5 (0.05) | 0.36 (0.036) |
| at 350 °C, 8sec Pulse | | | 0.49 (0.049) | 0.51 (0.051) | 0.36 (0.036) |
| at 375 °C, 3sec Pulse | 0.21 (0.021) | NA | 0.61^{a} (0.061) | 0.61^{a} (0.061) | 0.5^{a} (0.05) |
| at 375 °C, 6sec Pulse | 0.29 (0.029) | NA | 0.71^{b} (0.071) | 0.68^{b} (0.068) | 0.46^{b} (0.046) |

| | | | | | |
|---|---|---|---|---|---|
| 1: Bis(iso-propoxy)bis(2,2,6,6-tetramethyl-3,5-heptanedionato)titanium (comparative example) 2: Bis(iso-propoxy)bis(N,N-Dimethylacetoacetamido)titanium 3: Bis(n-propoxy)bis(methyl 4,4-dimethyl-3-oxopentanoato)titanium 4: Bis(methoxy)bis(methyl 4,4-dimethyl-3-oxopentanoato)titanium 5: Bis(ethoxy)bis(ethyl 4,4-dimethyl-3-oxopentanoato)titanium a: 4 sec pulse b: 8 sec pulse | | | | | |

In this or other embodiments, it is understood that the steps of the methods described herein may be performed in a variety of orders, may be performed sequentially or overlapping (e.g., during at least a portion of another step), and any combination thereof. The respective step of supplying the precursors and the oxygen source gases may be performed by varying the duration of the time for supplying them to change the stoichiometric composition of the resulting metal oxide film. For multicomponent metal oxide films, a strontium-containing precursor, a barium-containing precursor or both precursors can be alternately introduced in step a into the reactor chamber.

In one embodiment of the method described herein, the temperature of the substrate in the reactor, i.e., a deposition chamber, is below or from 250 to 400°C, preferably between 300 and 400 °C. In this or other embodiments, the pressure may range from about 0.1 Torr (13 Pa) to about 100 Torr (13 kPa) or from about 0.1 Torr (13 Pa) to about 5 Torr (667 Pa).

An oxidizer may be introduced into the reactor in the form of at least one oxygen source and/or may be present incidentally in the other precursors used in the deposition process. Suitable oxygen source gases may include, for example; water (H₂O) (e.g., deionized water, purifier water, and/or distilled water), oxygen (O₂), oxygen plasma, ozone (O₃), nitric oxide (NO), nitrogen dioxide (NO₂), nitrous oxide (N₂O), carbon monoxide (CO), carbon dioxide (CO₂) and combinations thereof. In certain embodiments, the oxygen source comprises an oxygen source gas that is introduced into the reactor at a flow rate ranging from about 1 to about 2000 square cubic centimeters (sccm) or from about 1 to about 1000 sccm. The oxygen source can be introduced for a time that ranges from about 0.1 to about 100 seconds, preferably from about 1 to 10 seconds

The deposition methods disclosed herein may involve one or more purge gases. The purge gas, which is used to purge away unconsumed reactants and/or reaction byproducts, is an inert gas, that does not react with the precursors and may preferably be selected from the group consisting of argon (Ar), nitrogen (N₂), helium (He), hydrogen (H₂) and mixture thereof. In certain embodiments, a purge gas, such as Ar, is supplied into the reactor at a flow rate ranging from about 10 to about 2000 sccm for about 0.1 to 1000 seconds, preferably from 1 to 50 seconds, thereby purging the unreacted material and any byproduct that remain in the reactor.

In one particular embodiment, the Group 4 metal-containing precursor is a liquid, which exhibits at least one of the following properties: low molecular weight (e.g., 500 m.u. or below), low viscosity (600 cP and below), low melting point (e.g., 60°C or below), and high vapor pressure (e.g., 0.5 torr (67 Pa) or greater).

In one embodiment the method is used for making a Group 4 metal-containing oxide film, metal-containing nitride film, metal-containing oxynitride film, metal-containing silicate film, multi-component metal oxide film, and any combination or laminate thereof, which may be used, for example, in fabricating semiconductor devices.

In one embodiment, the method disclosed herein provides a Group 4 metal or multi-component metal oxide film, that has a dielectric constant substantially higher than that of either conventional thermal silicon oxide, silicon nitride, or zirconium/hafnium oxide dielectric.

In one embodiment of the method disclosed herein, a Group 4 metal silicate or metal silicon oxynitride film is formed onto at least one surface of a substrate using a Group 4 metal-containing precursor of Formula I, a silicon-containing precursor, an oxygen source, and optionally a nitrogen source. Although metal-containing and silicon-containing precursors typically react in either liquid form or gas phase, thereby preventing film formation, the method disclosed herein avoids pre-reaction of the metal containing and silicon-containing precursors by using ALD method that separate the precursors prior to and/or during the introduction to the reactor. In certain embodiments, the method disclosed herein forms the metal oxide films using metal ketoiminate precursors and an oxygen source.

As mentioned previously, the method disclosed herein forms the metal-containing films using at least one metal precursor, such as the Group 4 metal-containing precursors described herein, optionally at least one silicon-containing precursor, optionally an oxygen source, optionally an additional metal-containing or other metal-containing precursor precursor, optionally a reducing agent, and optionally a nitrogen source. Although the precursors and sources used herein may be sometimes described as "gaseous", it is understood that the precursors can be either liquid or solid, which are transported with or without an inert gas into the reactor via direct vaporization, bubbling or sublimation. In some case, the vaporized precursors can pass through a plasma generator.

In certain embodiments, other metal-containing precursors can be used, in addition to the Group 4 metal-containing precursors described herein. Metals commonly used in semiconductorfabrication that can be used as the metal component for a metal amide include: titanium, tantalum, tungsten, hafnium, zirconium, cerium, zinc, thorium, bismuth, lanthanum, strontium, barium, lead, and combinations thereof.

Examples of other metal-containing precursors that may be used with the method disclosed herein include, but are not limited to, tetrakis(dimethylamino)zirconium (TDMAZ), tetrakis(diethylamino)zirconium (TDEAZ), tetrakis(ethylmethylamino)zirconium (TEMAZ), tetrakis(dimethylamino)hafnium (TDMAH), tetrakis(diethylamino)hafnium (TDEAH), and tetrakis(ethylmethylamino)hafnium (TEMAH), tetrakis(dimethylamino)titanium (TDMAT), tetrakis(diethylamino)titanium (TDEAT), tetrakis(ethylmethylamino)titanium (TEMAT), tert-butylimino tri(diethylamino)tantalum (TBTDET), tert-butylimino tri(dimethylamino)tantalum (TBTDMT), tert-butylimino tri(ethylmethylamino)tantalum (TBTEMT), ethylimino tri(diethylamino)tantalum (EITDET), ethylimino tri(dimethylamino)tantalum (EITDMT), ethylimino tri(ethylmethylamino)tantalum (EITEMT), tert-amylimino tri(dimethylamino)tantalum (TAIMAT), tert-amylimino tri(diethylamino)tantalum, pentakis(dimethylamino)tantalum, tert-amylimino tri(ethylmethylamino)tantalum, bis(tert-butylimino)bis(dimethylamino)tungsten (BTBMW), bis(tert-butylimino)bis(diethylamino)tungsten, bis(tert-butylimino)bis(ethylmethylamino)tungsten, bis(2,2,6,6-tetramethyl-3,5-heptanedionato)strontium, bis(2,2,6,6-tetramethyl-3,5-heptanedionato)barium, M(RₙC₅H₅₋ₙ)₂, wherein n=1-5, R is selected from linear or branched C₁₋₆ alkyls; M(RₙC₄NH₄₋ₙ)₂, wherein n=2-4, R is selected from linear or branched C₁₋₆ alkyls, and M(RₙN₂H₃₋ₙ)₂, where n=2-3, R is selected from linear or branched C₁₋₆ alkyls, and combinations thereof.

In one embodiment, the metal-containing precursors, that can be used, in addition to the Group 4 metal precursors described herein, to provide a metal-containing film, are polydentate β-ketoiminates which are described, for example, in Applicants' co-pending application US 2007/0248754 A1, US Serial No. 11/945678 filed on November 27, 2007, Applicants' co-pending application U.S. Serial No. 12/266,806 which was filed on November 11, 2008 Applicants' co-pending application or U.S. Serial No. 12/245,196 which was filed on October 3, 2008, all of which are incorporated herein by reference in their entirety.

In certain embodiments, the polydentate β-ketoiminates may incorporate an alkoxy group in the imino group. The polydentate β-ketoiminates are selected from the group represented by the following Structures A and B.

Structure A is defined as: 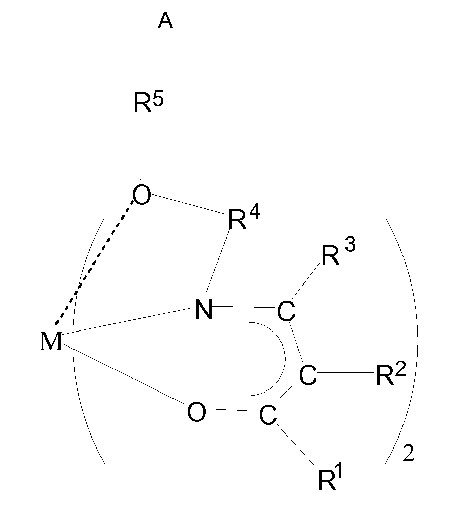 wherein M is a Group 2 metal such as, for example, magnesium, calcium, strontium, and barium. Preferably, M is strontium or barium. The organo groups (i.e., the R groups) employed in the complexes of the present invention may include a variety of organo groups and they may be linear or branched. In preferred embodiments, R¹ is selected from the group consisting of: a C₁ to C₁₀ alkyl, a C₁ to C₁₀ alkoxyalkyl, a C₁ to C₁₀ alkoxy, a C₁ to C₁₀ fluoroalkyl, a C₁ to C₁₀ cycloaliphatic, and a C₆ to C₁₀ aryl. As used herein, the group "alkoxyalkyl" refers to an ether-like moiety that includes a C-O-C fragment. Examples include -CH₂CH₂-O-CH₂CH₂-O-CH₃ and -CH₂CH₂-O-CH₂-O-CH₃. Preferably, R¹ is a bulky alkyl group containing 4 to 6 carbon atoms, such as, for example; a tert-butyl group, a sec-butyl, and a tert-pentyl group. The most preferred R¹ group is tert-butyl or tert-pentyl. Preferably, R² is selected from the group consisting of: hydrogen, a C₁ to C₁₀ alkyl, a C₁ to C₁₀ alkoxyalkyl, a C₁ to C₁₀ alkoxy, a C₃ to C₁₀ cycloaliphatic, and a C₆ to C₁₀ aryl. More preferably, R² is hydrogen, or a C₁ to C₂ alkyl. Preferably, R³ is selected from the group consisting of: a C₁ to C₁₀ alkyl, a C₁ to C₁₀ alkoxyalkyl, a C₁ to C₁₀ alkoxy, a C₃ to C₁₀ cycloaliphatic, and a C₆ to C₁₀ aryl. More preferably, R³ is a C₁ to C₂ alkyl. Preferably, R⁴ is a C₁ to C₆ linear or branched alkylene and, more preferably, R⁴ contains a branched alkylene bridge containing 3 or 4 carbon atoms and having at least one chiral center carbon atom. Without intending to be bound by a particular theory, it is believed that the chiral center in the ligand plays a role in lowering the melting point, as well as increasing the thermal stability of the complex. Preferably, R⁵ is selected from the group consisting of: a C₁ to C₁₀ alkyl, a C₁ to C₁₀ fluoroalkyl, a C₃ to C₁₀ cycloaliphatic, and a C₆ to C₁₀ aryl. More preferably, R⁵ is a C₁ to C₂ alkyl.

Specific examples of these metal containing complexes are represented by the following Structure B: 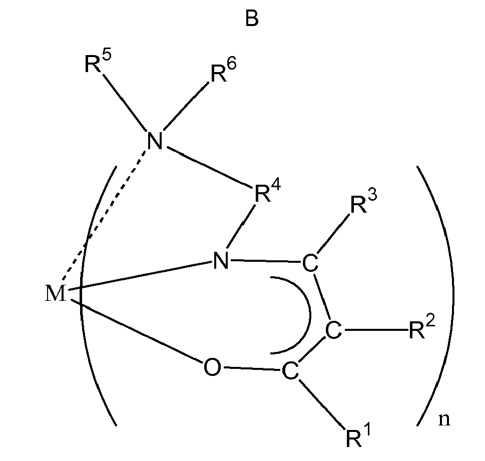 wherein M is a metal having a valence of from 2 to 5 wherein R¹ is selected from the group consisting of C₁₋₁₀ alkyl, C₂₋₁₀ alkoxyalkyl, C₁₋₁₀ fluoroalkyl, C₄₋₁₀ cycloaliphatic, and C₆₋₁₂ aryl; R² is selected from the group consisting of hydrogen, C₁₋₁₀ alkyl, C₁₋₁₀ alkoxy, C₄₋₁₀ cycloaliphatic, and C₆₋₁₂ aryl; R³ is selected from the group consisting of C₁₋₁₀ alkyl, C₂₋₁₀ alkoxyalkyl, C₁₋₁₀ fluoroalkyl, C₄₋₁₀ cycloaliphatic, and C₆₋₁₂ aryl; R⁴ is a C₃₋₁₀ linear or branched alkyl bridge, preferably R⁴ has at least one chiral carbon atom; R⁵⁻⁶ are individually selected from the group consisting of C₁₋₁₀ alkyl, C₁₋₁₀ fluoroalkyl, C₄₋₁₀ cycloaliphatic, C₆₋₁₂ aryl, and heterocyclic containing either oxygen, or nitrogen atoms; and n is an integer equal to the valence of the metal M.

In one embodiment, metal precursors of this invention can be used in addition to at least one metal-ligand complex, wherein one or more ligands are selected from the group consisting of: β-diketonates, β-diketoesterates, β-ketoiminates, β-diiminates, alkyls, carbonyl, alkyl carbonyl, cyclopentadienyls, pyrrolyl, imidazolyl, amidinate, alkoxide, and mixtures thereof, wherein the ligand can be monodentate, bidentate and multidentate, complexing to the metal atoms, and the metal is selected from Group 2 to 16 elements of the Periodic Table of the Elements. Examples of these complexes comprise: bis(2,2-dimethyl-5-(dimethylaminoethyl-imino)-3-hexanonato-N,O,N')strontium, bis(2,2-dimethyl-5-(1-dimethylamino-2-propylimino)-3-hexanonato-N,O,N')strontium, tetrakis(2,2,6,6-tetramethyl-3,5-heptanedionato)cerium (IV), tris(2,2,6,6-tetramethyl-3,5-heptanedionato)lanthanum, Sr[(^{t}Bu)₃Cp]₂, Ba[(^{t}Bu)₃Cp]₂, LaCp₃, La(MeCp]₃, La(EtCp)₃, La(ⁱPrCp)₃, zirconium tert-butoxide, strontium bis(2-tert-butyl-4,5-di-tert-amylimidazolate), barium bis(2-tert-butyl-4,5-di-tert-amylimidazolate), barium bis(2,5-di-tert-butyl-pyrrolyl), where "Me" is methyl, "Et" is ethyl, "Pr" is propyl and "Cp" is cyclopentadienyl.

In one embodiment, metal precursors of this invention can be used for deposition of: titanium oxide, doped titanium oxide, doped zirconium oxide, strontium titanate (STO) and barium strontium titanate (BST).

In embodiments wherein the metal film deposited is a metal silicate, the deposition process further involves the introduction of at least one silicon-containing precursor. Examples of suitable silicon-containing precursors, include: a monoalkylaminosilane precursor, a hydrazinosilane precursor, or combinations thereof. In certain embodiments, the silicon-containing precursor comprises a monoalkylaminosilane precursor having at least one N-H fragment and at least one Si-H fragment. Suitable monoalkylaminosilane precursors containing both the N-H fragment and the Si-H fragment include, for example: bis(tert-butylamino)silane (BTBAS), tris(tert-butylamino)silane, bis(iso-propylamino)silane, tris(iso-propylamino)silane, and mixtures thereof. In one embodiment, the monoalkylaminosilane precursor has the formula (R⁷NH) ₙSiR⁸ ₘH₄₋₍ₙ₊ₘ₎ wherein R⁷ and R⁸ are the same or different and independently selected from the group consisting of C₁₋₁₀ alkyl, vinyl allyl, phenyl, C₄₋₁₀ cyclic alkyl, C₁₋₁₀ fluoroalkyl, and C₁₋₁₀ silylalkyl and wherein n is a number ranging from 1 to 3, m is a number ranging from 0 to 2, and the sum of "n + m" is a number that is less than or equal to 3. In another embodiment, the silicon-containing precursor comprises a hydrazinosilane having the formula (R⁹₂N-NH)ₓSiR¹⁰_{y}H_{4-(x+y)} wherein R⁹ and R¹⁰ are same or different and independently selected from the group consisting of C₁₋₁₀ alkyl, vinyl, allyl, phenyl, cyclic alkyl, fluoroalkyl, silylalkyls and wherein x is a number ranging from 1 to 2, y is a number ranging from 0 to 2, and the sum of "x + y" is a number that is less than or equal to 3. Examples of suitable hydrazinosilane precursors include, but are not limited to, bis(1,1-dimethylhydrazino)-silane, tris(1,1-dimethylhydrazino)silane, bis(1,1-dimethylhydrazino)ethylsilane, bis(1,1-dimethylhydrazino)isopropylsilane, bis(1,1-dimethylhydrazino)vinylsilane, and mixtures thereof.

Depending upon the deposition method, in certain embodiments, the silicon-containing precursor may be introduced into the reactor at a predetermined molar volume, or from about 0.1 to about 1000 micromoles. In this or other embodiments, the silicon-containing precursor may be introduced into the reactor for a predetermined time period, or from about 0.001 to about 500 seconds. The silicon-containing precursors react with the metal hydroxyl groups formed by the reaction of the metal amide with the oxygen source and become chemically adsorbed onto the surface of the substrate, which results in the formation of a silicon oxide or a silicon oxynitride via metal-oxygen-silicon and metal-oxygen-nitrogen-silicon linkages, thus providing the metal silicate or the metal silicon oxynitride film.

In certain embodiments, such as, for example, for those embodiments where a metal silicon oxynitride film is deposited, an additional gas, such as a nitrogen source gas, may be introduced into the reactor. Examples of nitrogen source gases may include, for example: NO, NO₂, ammonia, hydrazine, monoalkylhydrazine, dialkylhydrazine, and combinations thereof.

The respective step of supplying the precursors, the oxygen source, and/or other precursors or source gases may be performed by changing the time for supplying them to change the stoichiometric composition of the resulting metal oxide film, including but not limited to: strontium titanate, barium titanate, barium/strontium titanate, doped lanthanide oxide, metal silicate, metal silicon oxynitride film, or other metal-containing film.

Energy is applied to at least one of the: precursor, oxygen source gas, reducing agent, or combination thereof to induce reaction and to form the metal-containing film on the substrate. Such energy can be provided by, but not limited to: thermal, plasma, pulsed plasma, helicon plasma, high density plasma, inductively coupled plasma, X-ray, e-beam, photon, and remote plasma methods. In certain embodiments, a secondary radio frequency (RF) frequency source can be used to modify the plasma characteristics at the substrate surface. In embodiments wherein the deposition involves plasma, the plasma-generated process may comprise a direct plasma-generated process, in which plasma is directly generated in the reactor, or alternatively a remote plasma-generated process, in which plasma is generated outside of the reactor and supplied into the reactor.

The Group 4 metal-containing precursor and/or other metal containing precursors may be delivered to the reaction chamber, such as an ALD reactor, in a variety of ways. In one embodiment, a liquid delivery system may be utilized. In an alternative embodiment, a combined liquid delivery and flash vaporization process unit may be employed, such as, for example, the turbo vaporizer manufactured by MSP Corporation of Shoreview, MN, USA, to enable low volatility materials to be volumetrically delivered, leading to reproducible transport and deposition without thermal decomposition of the precursor.

In one embodiment of the method described herein: ozone, oxygen plasma or water plasma are employed. The gas lines connecting from the precursor canisters to the reaction chamber are heated to one or more temperatures ranging from about 150°C to about 200°C depending upon the process requirements, and the container of the Group 4 metal-containing precursor is kept at one or more temperatures ranging from about 100°C to about 190°C for bubbling, wherein the solution comprising the Group 4 metal-containing precursor is injected into a vaporizer kept at one or more temperatures ranging from about 150°C to about 180°C for direct liquid injection. A flow of 100 sccm of argon gas may be employed as a carrier gas to help deliver the vapor of the Group 4 metal-containing precursor to the reaction chamber during the precursor pulsing. The reaction chamber process pressure is about 1 Torr (133 Pa). In a typical ALD process, the substrate, such as for example silicon oxide, metal nitride, metal or metal oxide, are heated on a heater stage in a reaction chamber that is exposed to the Group 4 metal-containing precursor, initially, to allow the complex to chemically adsorb onto the surface of the substrate. An inert gas, such as argon gas, purges away unadsorbed excess complex from the process chamber. After sufficient Ar purging, an oxygen source is introduced into reaction chamber to react with the absorbed surface followed by another inert gas purge to remove reaction by-products from the chamber. The process cycle can be repeated to achieve the desired film thickness.

In liquid delivery formulations, the precursors described herein may be delivered in neat liquid form, or alternatively, may be employed in solvent formulations or compositions comprising same. Thus, in certain embodiments the precursor formulations may include solvent component(s) of suitable character as may be desirable and advantageous in a given end use application to form a film on a substrate. The solvent employed in solubilizing the precursor for use in a deposition process may comprise any compatible solvent or their mixture, including; aliphatic hydrocarbons (e.g., pentane, hexane, heptane, octane, decane, dodecane, ethylcyclohexane, propylcyclohexane), aromatic hydrocarbons (e.g., benzene, toluene, ethylbenzene, xylene, mesitylene, ethyl toluene and other alkyl substituted aromatic solvents), ethers, esters, nitriles, alcohols, amines (e.g., triethylamine, tert-butylamine), imines and carbodiimides (e.g., N,N'-diisopropylcarbodiimide), ketones, aldehydes, amidines, guanadines, isoureas, and the like. Further examples of suitable solvents are selected from the group consisting of glyme solvents having from 1 to 20 ethoxy -(C₂H₄O)- repeat units (e.g. dimethoxyethane, 1,2 -diethoxyethane and diglyme); organic ethers selected from the group consisting of propylene glycol groups(e.g. dipropylene glycol dimethyl ether) ; C₂-C₁₂ alkanols; organic ethers selected from the group consisting of dialkyl ethers comprising C₁-C₆ alkyl moieties, C₄-C₈ cyclic ethers (e.g. tetrahydrofuran and dioxane); C₁₂-C₆₀ crown O₄-O₂₀ ethers wherein the prefixed Cᵢ range is the number i of carbon atoms in the ether compound and the suffixed Oᵢ range is the number i of oxygen atoms in the ether compound; C₆-C₁₂ aliphatic hydrocarbons; C₆-C₁₈ aromatic hydrocarbons; organic esters; organic amines, polyamines, aminoethers and organic amides. Another class of solvents that offers advantages is the organic amide class of the form: RCONR'R" wherein R and R' are alkyl having from 1-10 carbon atoms and they can be connected to form a cyclic group via (CH₂)ₙ, wherein n is from 4-6, preferably 5, and R" is selected from alkyl having from 1 to 4 carbon atoms and cycloalkyl. N-methyl- or N-ethyl- or N-cyclohexyl-2-pyrrolidinones, *N*,*N-*Diethylacetamide, and *N*,*N*-Diethylformamide are examples.

The utility of specific solvent compositions for particular precursors may be readily empirically determined, to select an appropriate single component or multiple component solvent medium for the liquid delivery vaporization and transport of the specific Group 4 precursor that is employed.

In another embodiment, a direct liquid delivery method can be employed by dissolving the Group 4 metal-containing precursor in a suitable solvent or a solvent mixture to prepare a solution with a molar concentration from 0.01 to 2 M, depending the solvent or mixed-solvents employed. The solvent employed herein may comprise any compatible solvents or their mixture including, but not limited to: aliphatic hydrocarbons, aromatic hydrocarbons, linear or cyclic ethers, esters, nitriles, alcohols, amines, polyamines, aminoethers and organic amides, preferably a solvent with a high boiling point, such as: octane, ethylcyclohexane, decane, dodecane, xylene, mesitylene and dipropylene glycol dimethyl ether.

The method described herein also includes a cyclic deposition process for the formation of ternary metal oxide films, wherein a plurality of precursors are sequentially introduced into a deposition chamber, vaporized and deposited on a substrate under conditions for forming a ternary metal oxide film.

In one particular embodiment, the resultant metal oxide films can be exposed to a post-deposition treatment, such as a plasma treatment, to densify the film.

As mentioned previously, the method described herein may be used to deposit a metal-containing film on at least a portion of a substrate. Examples of suitable substrates include, but are not limited to: semiconductor materials, such as strontium titanate, barium strontium titanate, yttrium oxide doped with titanium, lanthanum oxide doped with titanium, and other lanthanide oxides doped with titanium.

Further aspects of the present invention include:
#1. A method for deposition of at least one metal containing film selected from the group consisting of titanium, hafnium and zirconium under atomic layer deposition conditions onto a substrate comprising contacting the substrate with a composition having the formula: 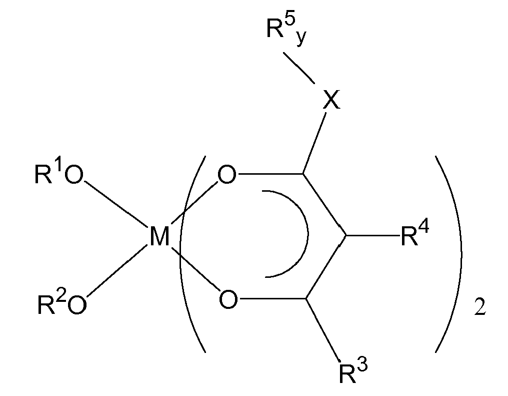 wherein M is a Group 4 metal selected from the group consisting of Ti, Zr, and Hf; wherein R¹ and R² can be same or different selected from the group consisting of linear or branched C₁₋₁₀ alkyl groups and a C₆₋₁₂ aryl; R³ is selected from the group consisting of linear or branched C₁₋₁₀ alkyls and a C₆₋₁₂ aryl; R⁴ is selected from the group consisting of hydrogen, C₁₋₃ alkyls and a C₆₋₁₂ aryl; R⁵ is selected from the group consisting of C₁₋₁₀ linear or branched alkyls and a C₆₋₁₂ aryl; X = O or N wherein when X = O, y = 1, and R^{1,2 and 5} are the same, and when X = N, y = 2 and each R⁵ can be the same or different.
#2. The method of #1 wherein the composition is in a solvent selected from the group consisting of pentane, hexane, heptane, octane, decane, dodecane, ethylcyclohexane, propylcyclohexane, benzene, toluene, ethylbenzene, xylene, mesitylene, ethyl toluene, ethers, esters, nitriles, alcohols, amines, triethylamine, tert-butylamine, imines, carbodiimides, N,N'-diisopropylcarbodiimide, ketones, aldehydes, amidines, guanadines, isoureas, glyme having from 1 to 20 ethoxy -(C₂H₄O)- repeat units, dimethoxyethane, 1,2 - diethoxyethane and diglyme, organic ethers, propylene glycol, dipropylene glycol dimethyl ether, C₂-C₁₂ alkanols; organic ethers, dialkyl ethers comprising C₁-C₆ alkyl moieties, C₄-C₈ cyclic ethers, tetrahydrofuran and dioxane, C₁₂-C₆₀ crown O₄-O₂₀ ethers, C₆-C₁₂ aliphatic hydrocarbons, C₆-C₁₈ aromatic hydrocarbons, organic esters, organic amines, polyamines, aminoethers, organic amides organic amide class of the form RCONR'R" wherein R and R' are alkyl having from 1-10 carbon atoms and they can be connected to form a cyclic group (CH₂)ₙ, wherein n is from 4-6, and R" is selected from alkyl having from 1 to 4 carbon atoms, cycloalkyl. N-methyl- or N-ethyl- or N-cyclohexyl-2-pyrrolidinones, *N*,*N*-Diethylacetamide, and *N*,*N*-Diethylformamide.
#3. A method for deposition of at least one metal containing film selected from the group consisting of titanium, hafnium and zirconium under atomic layer deposition conditions onto a substrate comprising contacting the substrate with a composition of Formula I, below: 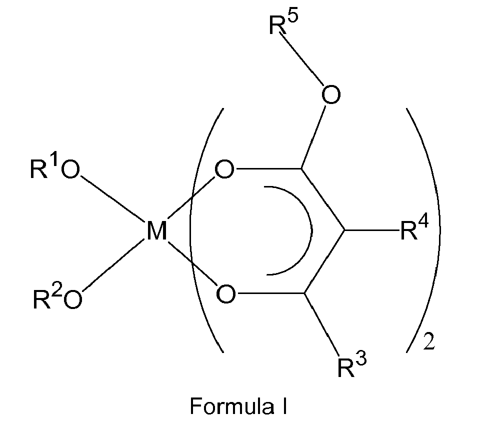 wherein M is a Group 4 metal selected from the group consisting of Ti, Zr, and Hf; wherein R¹, R² and R⁵ are the same selected from the group consisting of linear or branched C₁₋₁₀ alkyl and a C₆₋₁₂ aryl; R³ is selected from the group consisting of linear or branched C₁₋₁₀ alkyls and a C₆₋₁₂ aryl; R⁴ is selected from the group consisting of hydrogen, C₁₋₃ alkyls and a C₆₋₁₂ aryl.
#4. A method for deposition of multi-component metal oxides at least one of which is selected from the group consisting of titanium, hafnium and zirconium under atomic layer deposition conditions onto a substrate comprising contacting the substrate with a composition of #3.
#5. The method of #4 wherein the multi-component metal oxides are selected from the group of strontium titanate, barium strontium titanate, and barium titanate.
#6. The method of #3 wherein the composition is a neat liquid.
#7. The method of #3 wherein the composition is a solution consisting of Group 4 metal composition of Formula I and a solvent.
#8. The method of #7 wherein the solvent is selected from the group consisting of octane, ethylcyclohexane, dodecane, toluene, xylene, mesitylene, diethylbezene, and mixture thereof.
#9. A method for deposition of at least one metal containing film selected from the group consisting of titanium, hafnium and zirconium under atomic layer deposition conditions onto a substrate comprising contacting the substrate with a composition of Formula II, below: 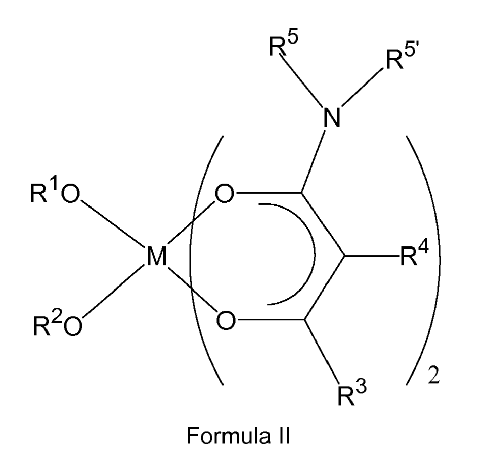 wherein M is a Group 4 metal selected from the group consisting of Ti, Zr, and Hf; wherein R¹ and R² can be same or different selected from the group consisting of linear or branched C₁₋₁₀ alkyl s and a C₆₋₁₂ aryl; R³ is selected from the group consisting of linear or branched C₁₋₁₀ alkyls and a C₆₋₁₂ aryl; R⁴ is selected from the group consisting of hydrogen, C₁₋₁₀ alkyls and a C₆₋₁₂ aryl; R⁵ and R^{5'} are independently selected from the group consisting of C₁₋₁₀ linear or branched alkyls and a C₆₋₁₂ aryl.
#10. A method for deposition of multi-component metal oxides at least one of which is selected from the group consisting of titanium, hafnium and zirconium under atomic layer deposition conditions onto a substrate comprising contacting the substrate with a composition of #9.
#11. The method of #10 wherein the multi-component metal oxides are selected from the group of strontium titanate, barium strontium titanate, and barium titanate.
#12. The method of #10 wherein the multicomponent metal oxides are selected from the group of titanium oxide doped with lanthanide, zirconium oxide doped with lanthanide, and hafnium oxide doped with lanthanide.
#13. The method of #9 wherein the composition is a neat liquid.
#14. The method of #9 wherein the composition is a solution consisting of a Group 4 metal composition and a solvent.
#15. The method of #14 wherein the solvent is selected from the group consisting of octane, ethylcyclohexane, dodecane, toluene, xylene, mesitylene, diethylbezene, and mixture thereof.
#16. The method of #1 further comprises the steps of: (a) introducing the composition in a vapor state into a reaction chamber and chemisorbing the composition onto a substrate which is heated; (b) purging away unreacted composition; (c) introducing an oxygen source onto the heated substrate to react with the sorbed composition; and (d) purging away the unreacted oxygen source and reaction by-products.
#17. The method of #16 wherein steps (a) through (d) are repeated until a desired film depth is achieved.
#18. The method of #16 wherein the composition is in a solvent.
#19. The method of #18 wherein the solvent is selected from the group consisting of octane, ethylcyclohexane, dodecane, toluene, xylene, mesitylene, diethylbezene, and mixture thereof.
#20. The method of #18 wherein the vapors of the composition in a solvent are delivered via injection into a vaporizer.

The following examples illustrate the method for preparing a Group 4 metal-containing precursor and deposition of Group 4 metal-containing films, described herein, but are not intended to limit it in any way.

### Example 1

### Synthesis of bis(iso-propoxy)bis(methyl 4,4-dimethyl-3-oxopentanoato)titanium

To 2.00 g (7.04 mmol) Ti(IV)isopropoxide was slowly added 2.25 g (14.24 mmol) methyl 4,4-dimethyl-3-oxopentanoate (MDOP) at 25 °C. The resulting yellow viscous solution was heated to 43 °C due to exothermic reaction and then agitated at 25 °C for 2 hours. Removal of all volatiles generated a white glassy solid. The solid was re-dissolved in 4 ml of hexanes, the mixture was agitated and hexanes was removed under vacuum to obtain white crystalline solid, 2.65 g (78 % yield). Melting point of the product was 68 °C. 2.12 g of solid was purified by sublimation at 85 °C under vacuum (0.2 torr (27 Pa)). 2.03 g of sublimed product was collected (96 % sublimation yield).

¹H-NMR (nuclear magnetic resonance) confirms no uncoordinated methyl 4,4-dimethyl-3-oxopentanoate and shows the desired ratio of ⁱPrO to MDOP coordinated to Ti being two ⁱPrO's to two MDOP ligands (ⁱPrO is iso-propoxy).

¹H-NMR (500 MHz, THF) δ(ppm): 5.12 (CH, MDOP), 4.69 (CH, O-iPr), 3.55 and 3.80 (OCH₃,MDOP), 1.40 [(CH₃)₂]_{,} 1.05 and 1.20 [C(CH₃)₃ and C(CH₃)₂].

A neat sample of this material was heated at 200 °C for one hour in a sealed NMR tube under nitrogen atmosphere, and the material quickly turned dark orange, indicating some decomposition. Gas chromatograph-mass spectroscopy (GC-MS) of the heated sample dissolved in acetone showed presence of both ketoesters: methyl 4,4-dimethyl-3-oxopentanoate (57.4 %) and iso-propyl 4,4-dimethyl-3-oxopentanoate (42.6 %, product of transesterification reaction). GC-MS of the non-heated sample dissolved in acetone showed presence of only methyl 4,4-dimethyl-3-oxopentanoate. ¹H NMR spectrum of the heated material dissolved in d₈-toluene also confirmed presence of various complexes containing both ketoesterate ligands and methoxy ligands (δ(ppm) 4.25 and 4.30), which were not present in the material before thermal treatment.

### Example 2

### Synthesis of bis(ethoxy)bis(methyl 4,4-dimethyl-3-oxopentanoato) titanium

To a solution of 2.0 g (8.78 mmol) Ti(IV) ethoxide in 6 mililiters (mL) of hexane was added 2.75 g (17.4 mmol) of MDOP. The resulting yellow solution was stirred for 16 hours at room temperature (RT), and all volatiles were removed under vacuum. 3.0 g of orange liquid (88 % crude yield) was purified by distillation at 180 °C under vacuum (0.2 torr (27 Pa)) to obtain 2.71 g of light yellow viscous liquid (79.9 % purified yield). ¹H-NMR of distilled product indicates presence of different ethoxy groups attributed to signals from ethoxide ligands and also from ethyl 4,4-dimethyl-3-oxopentanoato ligand (EDOP) likely formed by transesterification reaction. Gas chromatograph-mass spectroscopy (GC-MS) of acetone solution of distilled product confrimed presence of a mixture of methyl 4,4-dimethyl-3-oxopentanoate and ethyl 4,4-dimethyl-3-oxopentanoate present at - 2/1 ratio.

¹H-NMR (500 MHz, C₆D₆) δ(ppm): 5.40 (CH, ketoesters), 4.70 (OCH₂, ethoxy), 4.40 (OCH₃, methoxy), 4.0 (OCH₂, EDOP), 3.40 and 3.65 (OCH₃, MDOP), 1.35 (CH₃, ethoxide ), 1.15 and 1.26 (C(CH₃)₃, MDOP).

### Example 3

### Synthesis of bis(n-propoxy)bis(methyl 4,4-dimethyl-3-oxopentanoato) titanium

To a solution of 15.1 g (53.1 mmol) Ti(IV) n-propoxide in 30 g of anhydrous hexane at 5 °C was added 18.0g (113.9 mmol) MDOP. The resulting solution was agitated for 16 hours at room temperature (RT) and then refluxed for two hours. All volatiles were removed under vacuum and orange viscous liquid was obtained (24.74 g, 96.6 % crude yield). The material was distilled under vacuum at 190 °C to obtain 19.2 g of light yellow viscous liquid (75 % purified yield). ¹H-NMR of distilled product indicates presence of different n-propoxy groups attributed to signals from n-propoxide ligands and also from propyl 4,4-dimethyl-3-oxopentanoato ligand likely formed by transesterification reaction. GC-MS of acetone solution of distilled product confrimed presence of a mixture of methyl 4,4-dimethyl-3-oxopentanoate and propyl 4,4-dimethyl-3-oxopentanoate present at - 1/1 ratio.1H NMR of crude material containing > 90 % of bis(n-propoxy)bis(methyl 4,4-dimethyl-3-oxopentanoato) titanium (500 MHz, d₈- toluene δ(ppm): 5.20 (CH, MDOP), 4.47 (OCH₂, n-propoxy), 3.35 and 3.55 (OCH₃, MDOP), 1.57 (OCH₂, n-propoxy), 1.05 and 1.29 (C(CH₃)₃, MDOP), 0.92 (CH₃, n-propoxy).

¹H-NMR of the distilled material indicates it is a mixture of complexes containing both methyl 4,4-dimethyl-3-oxopentanoato and propyl 4,4-dimethyl-3-oxopentanoato ligands (500 MHz, d₈- toluene δ(ppm): 5.25 (CH, ketoesterates), 4.50 (OCH₂, n-propoxy), 4.3 (OCH₃, methoxy), 3.90 (OCH₂, ketoesterate), 3.35 and 3.55 (OCH₃, MDOP), 1.60 and 1.45 (OCH₂, n-propoxy), 1.05 and 1.20 (C(CH₃)₃, MDOP), 0.75 and 0.95 (CH₃, n-propoxide).

### Example 4

### Synthesis of bis(methoxy)bis(n-propyl 4,4-dimethyl-3-oxopentanoato) titanium

To a slurry of 0.43 g (2.50 mmol) of Ti(IV) methoxide in 5 mL of hexane was added 0.93 g (5.00 mmol) of n-propyl 4,4-dimethyl-3-oxopentanoate. The reaction mixture was agitated for 16 hours at RT and all Ti(IV) methoxide was dissolved. All volatiles were distilled under vacuum to obtain 1.0 g of light yellow liquid, - 83 % crude yield. The material was not purified by high temperature vacuum distillation to avoid exchange of methoxide ligand with the ester group.

¹H-NMR (500 MHz, d₈- toluene δ(ppm): 5.27 (CH, ketoesterate), 4.54 (OCH₃, methoxide), 4.3 (OCH₃, methoxide), 3.90 (OCH₂, ketoesterate), 1.49 (OCH₂, ketoesterate), 1.05 and 1.20 (C(CH₃)₃, ketoesterate), 0.75 (CH₃, ketoesterate).

A neat sample of this material was heated at 200 °C for one hour in a sealed NMR tube under nitrogen atmosphere and significant changes were observed in its ¹H NMR. A mixture of complexes containing methoxide, n-propoxide ligands and also n-propyl 4,4-dimethyl-3-oxopentanoate and methyl 4,4-dimethyl-3-oxopentanoate ligands was present after thermal treatment.

### Example 5

### Synthesis of bis(ethoxy)bis(ethyl acetoacetato)titanium

To a solution of 5.76g (25.24mmol) of Ti(IV)ethoxide in 50mL of tetrahydrofuran (THF) was added 6.57g (50.47mmol) of ethyl acetoacetate in 25mL of THF. The reaction mixture was refluxed for 16 hours after which removal of volatiles yielded a waxy red-orange solid weighing 9.9g. 3.41g of crude material was purified by distillation at 130°C under vacuum (125 mTorr (17 Pa)) to obtain 2.90 g white solid (85% purified yield). The melting point was measured by the Differential scanning calorimetry (DSC) to be 52°C.

¹H-NMR (500 MHz, C₆D₆) δ(ppm): 5.18 (CH), 4.73 (OCH₂CH₃), 3.95 and 3.92 (OCH₂CH₃, ketoester), 1.82 (CH₃, ketoester) 1.34 (OCH₂CH₃), 1.03 and 0.93 (OCH₂CH₃, ketoester).

### Example 6

### Synthesis of bis(methoxy)bis(methyl 4,4-dimethyl-3-oxopentanoato)titanium

To a suspension of 30.41g (176.76 mmol) of Ti(IV)methoxide in 175mL of THF was added 55.92 g (353.52 mmol) of methyl 4,4-dimethyl-3-oxopentanoate. The resulting reaction mixture was heated to reflux for 16 hours after which volatiles were removed. A beige milky oil was isolated and extracted with 150mL of hexane. It was then filtered through celite and removal of all volatiles yielded a viscous amber oil weighing 76.05g. The oil was taken up in 100mL of hexane and 65.70g of pale yellow solid was precipitated out at -78 °C with a yield of 88%.

The melting point was measured by the Differential scanning calorimetry (DSC) at 10 C/min heating rate to be 51 °C. DSC at 10 C/min in a pressurized pan shows no thermal effects due to decomposition up to - 270°C. TGA analysis shows less than 0.2 wt. % residue, implying that it can be used as a suitable precursor in a vapor deposition process.

¹H-NMR (500 MHz, C₆D₆) δ(ppm): 5.36 (CH), 4.39 (OCH₃, methoxy), 3.29 (OCH₃,ketoester), 1.19 [C(CH₃)₃].

A colorless plate-like crystal of bis(methoxy)bis(methyl 4,4-dimethyl-3-oxopentanoato)titanium was structurally characterized by X-ray single crystal analysis. The structure shows the titanium atom is coordinated with two methoxy and two methyl 4,4-dimethyl-3-oxopentanoato ligands in a distorted octahedral environment as the cisgeometrical isomer.

### Example 7

### Synthesis of bis(ethoxy)bis(ethyl 4,4-dimethyl-3-oxopentanoato) titanium

To a solution of 186.53g (817.58mmol) of Ti(IV)ethoxide in 300mL of THF at room temperature was added 281.61 g (1635.15mmol) of ethyl 4,4-dimethyl-3-oxopentanoate in 300mL of THF via canula. Resulting red orange solution was refluxed for 16 hours. Removal of volatiles yielded a viscous orange liquid that was purified by distillation at 150°C under vacuum (0.10 torr (13 Pa)) to obtain 370.47 g of yellow viscous liquid. The yield is 93%.

DSC at 10 C/min in a pressurized pan shows no thermal effects due to decomposition up to - 270°C. TGA analysis shows that it leaves almost no residue, implying that it can be used as a suitable precursor in a vapor deposition process.

¹H-NMR (500 MHz, C₆D₆) δ(ppm): 5.37 (CH), 4.70 (OCH₂CH₃), 3.97 and 3.92 (OCH₂CH₃, ketoester), 1.34 (OCH₂CH₃), 1.23 and 1.10 [C(CH₃)₃], 1.03 and 0.96 (OCH₂CH₃, ketoester).

### Example 8

### Synthesis of bis(n-propoxy)bis(n-propyl 4,4-dimethyl-3-oxopentanoato) titanium

To a solution of 0.76 g (2.67 mmol) of Ti(IV) n-propoxide in 1 g of hexane was added 1.00 g (5.38 mmol) of n-propyl 4,4-dimethyl-3-oxopentanoate. The reaction mixture was agitated for one hour at RT and then for 30 minutes at 60 °C. All volatiles were removed under vacuum to obtain 1.1 g of colorless liquid, - 69 % isolated yield. The material was purified by vacuum distillation (0.2 torr (26 Pa)) at 180 °C (pot temperature) and clear colorless liquid was collected. No changes in ¹H NMR spectra of the materials before and after high temperature vacuum distillation were observed, indicating good thermal and compositional stability of this complex.

¹H-NMR (500 MHz, d₈- toluene δ(ppm): 5.17 (CH, ketoesterate), 4.45 (OCH₂, n-propoxy), 3.86 and 3.74 (OCH₂, ketoesterate), 1.55 (CH₂, n-propoxy), 1.38 (CH₂, ketoesterate), 0.95 and 1.12 (C(CH₃)₃, ketoesterate), 0.90 (CH₃, n-propoxide), 0.70 (CH₃, ketoesterate).

### Example 9

### Thermal Stability of bis(methoxy)bis(methyl 4,4-dimethyl-3-oxopentanoato)titanium

A sample of bis(methoxy)bis(methyl 4,4-dimethyl-3-oxopentanoato)titanium was heated in a sealed NMR tube for one hour at 200 °C. TGA of heated material showed - 0.2 wt % residue, similar to TGA residue of the material prior to thermal treatment. ¹H NMR spectrum of the heated material dissolved in d⁸-toluene showed no significant changes to confirm compositional integrity of this precursor after heating for one hour at 200 °C.

### Example 10

### Comparison of thermal stability of bis(ethoxy)bis(ethyl 4,4-dimethyl-3-oxopentanoato) titanium and bis(ethoxy)bis(ethyl acetoacetato)titanium

Samples of bis(ethoxy)bis(ethyl 4,4-dimethyl-3-oxopentanoato) titanium and bis(ethoxy)bis(ethyl acetoacetato)titanium were sealed under nitrogen atmosphere inside Perkin Elmer high pressure DSC capsules and heated at 10 C/min to 400 °C. DSC data show better thermal stability of bis(ethoxy)bis(ethyl 4,4-dimethyl-3-oxopentanoato) titanium, where R² group is a branched alkyl (exotherm onset is 310 °C) compare to bis(ethoxy)bis(ethyl acetoacetato)titanium where R² group is a linear alkyl (exotherm onset is 278 °C). Thus, bis(ethoxy)bis(ethyl 4,4-dimethyl-3-oxopentanoato) titanium may provide higher ALD operating thermal window compare to bis(ethoxy)bis(ethyl acetoacetato)titanium.

### Example 11

### Viscosity of bis(ethoxy)bis(ethyl 4,4-dimethyl-3-oxopentanoato) titanium

Viscosity was measured using an AR-G2 rheometer (TA Instruments, New Castle, DE). Temperature was controlled at desired temperature using a Peltier heating element. A 60 mm diameter parallel plate geometry was used. After sample loading, 600 sec was allowed for thermal equilibration before shear rate sweep measurement. Viscosities were measured at shear rates ranging from 1 to 100 s⁻¹. Bis(ethoxy)bis(ethyl 4,4-dimethyl-3-oxopentanoato) titanium showed Newtonian behavior with a viscosity of 107.9 centipoise at 25 °C and 10.1 centipoise at 80 °C. Viscosity of bis(ethoxy)bis(ethyl 4,4-dimethyl-3-oxopentanoato) titanium can be decreased below 10 centipoise at 25 °C by using an additive having low viscosity, for example octane.

### Example 12

### Synthesis of bis(iso-propoxy)bis(N,N-diethylacetoacetamido) titanium

To a solution of 5.94 g (20.90 mmol) Ti(IV) iso-propoxide in 65 ml of tetrahydrofuran (THF) was added 6.57g (41.8 mmol) N,N-Diethylacetoacetamide in 10 ml of THF. The resulting solution was refluxed over night. All volatiles were removed under vacuum to provide 9.89g of orange solid (-99 % crude yield). Thermogravimetric analysis/differential scanning calorimetry (TGA/DSC) indicated it has a melting point of 75°C. See Bae, B.-J., K. Lee, W. S. Seo, M. A. Miah, K.-C. Kim and J. T. Park (2004). "Preparation of anatase TiO2 thin films with (OPri)2Ti(CH3COCHCONEt2)2 precursor by MOCVD." Bull. Korean Chem. Soc. FIELD Full Journal Title: Bulletin of the Korean Chemical Society 25(11): 1661-1666.

### Example 13

### Synthesis of bis(tert-butoxy)bis(N,N-diethylacetoacetamido) titanium

To a solution of 6.72g (19.74mmol) of Ti (IV) tert-butoxide in 65mL of THF was added 6.21 g (39.49mmol) of N,N-diethylacetoacetamide in 10mL of THF drop wise at room temperature. The reaction was heated to reflux for 16 hours, after which it was cooled to room temperature. All volatiles were removed under vacuum to provide 9.85g of orange solid (-99 % crude yield). TGA/DSC indicated it has a melting point of 67°C.

### Example 14

### Synthesis of bis(ethoxy)bis(N,N-diethylacetoacetamido) titanium

To a solution of 5.06g (22.20mmol) of Ti (IV) ethoxide in 65mL of THF was added 6.98g (44.41 mmol) of N,N-diethylacetoacetamide in 10mL of THF drop wise at room temperature. The reaction was heated to reflux for 16 hours, after which it was cooled to room temperature. All volatiles were removed under vacuum to provide 9.69g of orange solid (-97 % crude yield). TGA/DSC indicated it has a melting point of 60°C.

### Example 15

### Synthesis of bis(iso-propoxy)bis(N,N-dimethylacetoacetamido) titanium

To a solution of 57.08 g (200.84 mmol) Ti(IV) iso-propoxide in 200 ml of THF was added 51.88g (401.69 mmol) N,N-Dimethylacetoacetamide in 50 ml of THF. The resulting solution was refluxed over night. All volatiles were removed under vacuum to provide 79.84g of yellow solid (-99 % crude yield). TGA/DSC indicated it has a melting point of 76°C.

### Example 16

### Synthesis of bis(tert-butoxy)bis(N,N-dimethylacetoacetamido) titanium

To a solution of 7.89 g (23.45 mmol) Ti(IV) tert-butoxide in 65 ml of THF was added 6.06g (46.90 mmol) N,N-Dimethylacetoacetamide in 10 ml of THF. The resulting solution was refluxed over night. All volatiles were removed under vacuum to provide 10g of yellow solid (100 % crude yield). TGA/DSC indicated it has a melting point of 94°C. See Gornshtein, F., M. Kapon, M. Botoshansky and M. S. Eisen (2007). "Titanium and Zirconium Complexes for Polymerization of Propylene and Cyclic Esters." Organometallics 26(3): 497-507.

### Example 17

### ALD of bis(iso-propoxy)bis(N,N-dimethylacetoacetamido) titanium

This example describes an ALD deposition of TiO₂ using bis(iso-propoxy)bis(N,N-dimethylacetoacetamido) titanium and ozone. The deposition temperature range is 200 - 400 °C. The deposition chamber pressure ranges around 1.5 Torr (200 Pa), the container for bis(iso-propoxy)bis(N,N-Dimethylacetoacetamido) titanium was kept at 150°C. One cycle of ALD of TiO₂ consists of 4 steps.
1. Introduce titanium precursor via bubbling with Ar as carrier gas;
2. Ar purge to remove away any unsorbed titanium precursor with Ar;
3. Introduce ozone into the deposition chamber, and;
4. Ar purge to remove away any unreacted ozone with Ar.

In this example, TiO₂ films are obtained, showing a deposition temperature dependence of the resulting TiO₂ film. The typical ALD conditions are: Ti precursor pulse time was 3 seconds, the Ar purge time after Ti precursor pulse was 8 seconds, the ozone pulse time was 5 seconds, and the Ar purge time after ozone pulse was 10 seconds. The cycle is repeated 100 times.

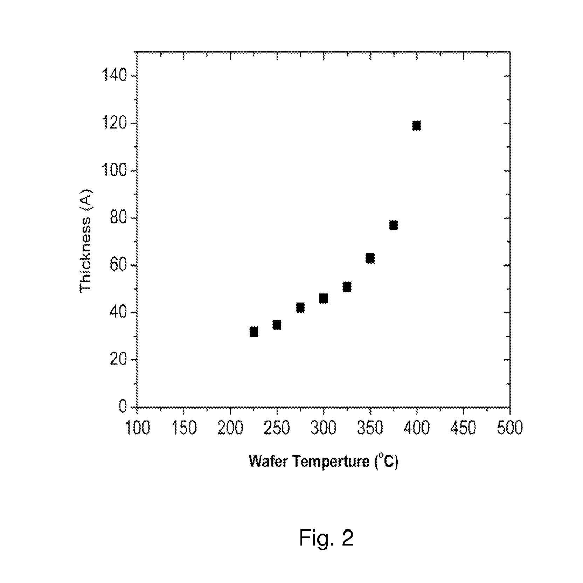

The results are depicted in Figure 2 in which the ALD process window was up to - 300 °C.

### Example 18

### ALD of TiO₂ using bis(methoxy)bis(methyl 4,4-dimethyl-3-oxopentanoato)titanium

This example describes an ALD deposition of TiO₂ using bis(methoxy)bis(methyl 4,4-dimethyl-3-oxopentanoato)titanium and ozone. The deposition temperature range is 200 - 400 °C. The deposition chamber pressure ranges around 1.5 Torr (200 Pa), the container for bis(methoxy)bis(methyl 4,4-dimethyl-3-oxopentanoato)titanium was kept at 120°C. One cycle of ALD of TiO₂ consists of 4 steps.
1. Introduce titanium precursor via bubbling with Ar as carrier gas;
2. Ar purge to remove away any left over titanium precursor with Ar;
3. Introduce ozone into the deposition chamber, and;
4. Ar purge to remove away any unreacted ozone.

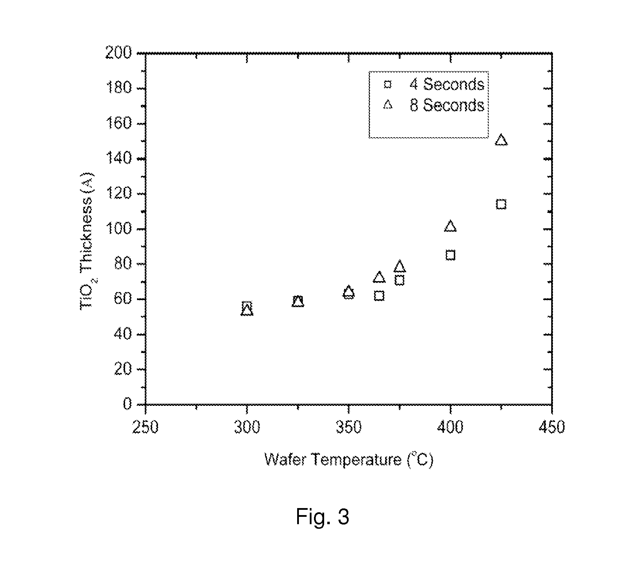

The typical ALD conditions are: Ti precursor pulse time was 4 or 8 seconds, the Ar purge time after Ti precursor pulse was 10 seconds, the ozone pulse time was 5 seconds, and the Ar purge time after ozone pulse was 10 seconds. The cycle was repeated 100 times. and TiO₂ films were obtained. The dependence of titanium oxide thickness on deposition temperature (Figure 3) suggests that ALD thermal process window can be up to - 370 °C and ALD rate can be as high as 0.6 A/cycle (0.06 nm/cycle).

### Example 19

### ALD of TiO₂ using bis(ethoxy)bis(ethyl 4,4-dimethyl-3-oxopentanoato)titanium

This example describes an ALD deposition of TiO₂ using bis(ethoxy)bis(ethyl 4,4-dimethyl-3-oxopentanoato)titanium and ozone. The deposition temperature range is 200 - 400 °C. The deposition chamber pressure ranges around 1.5 Torr (200 Pa). The container for bis(methoxy)bis(methyl 4,4-dimethyl-3-oxopentanoato)titanium was kept at 150°C. One cycle of ALD of TiO₂ consists of 4 steps.
1. Introduce titanium precursor via bubbling with Ar as carrier gas;
2. Ar purge to remove away any left over titanium precursor with Ar;
3. Introduce ozone into the deposition chamber, and;
4. Ar purge to remove away any unreacted ozone.

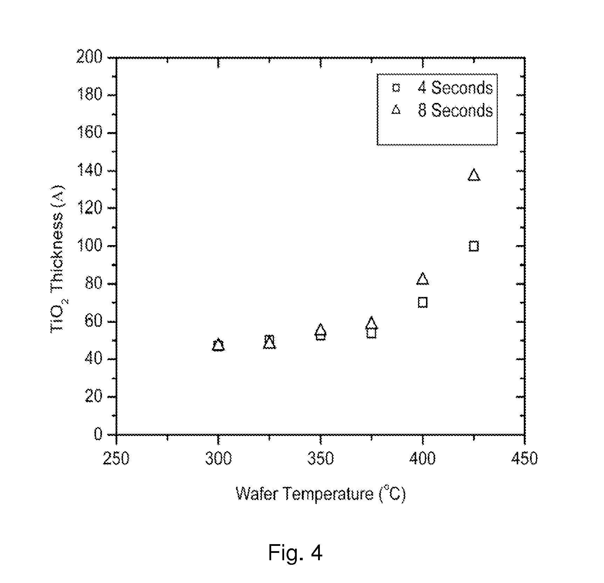

The typical ALD conditions are: Ti precursor pulse time was 4 or 8 seconds, the Ar purge time after Ti precursor pulse was 10 seconds, the ozone pulse time was 5 seconds, and the Ar purge time after ozone pulse was 10 seconds. The cycle was repeated 100 times. The dependence of titanium oxide thickness on deposition temperature is shown in Figure 4. The results suggest that ALD thermal process window can be up to - 375 °C with an ALD rate - 0.5 Å/cycle (0.05 nm/cycle).

### Example 20

### ALD of bis(ethoxy)bis(ethyl 4,4-dimethyl-3-oxopentanoato)titanium

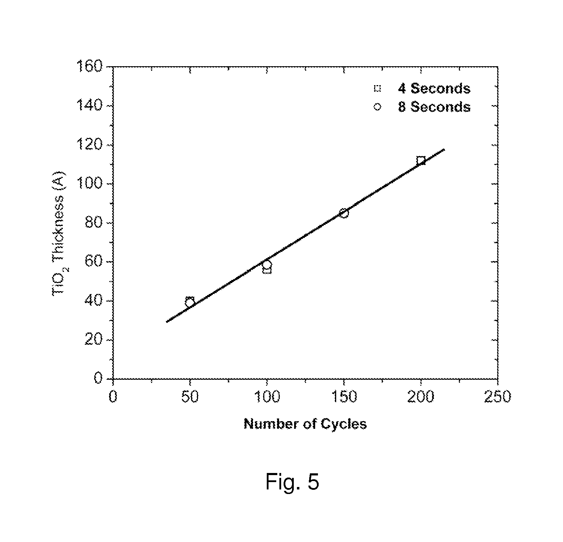

This example was designed to demonstrate that the process is true ALD at 375 °C with the following conditions: bis(ethoxy)bis(ethyl 4,4-dimethyl-3-oxopentanoato)titanium as Ti precursor with pulse time of 4 or 8 seconds, the Ar purge time after Ti precursor pulse was 10 seconds, the ozone pulse time was 5 seconds, and the Ar purge time after ozone pulse was 10 seconds. The cycles are repeated 50, 100, 150 times. The results are depicted in Figure 5, showing overlapping linear correlation between the thickness of resulting TiO₂ films and the number of cycles which confirms a true self-limiting ALD process at 375 °C.

### Example 21

### ALD of TiO₂ using bis(ethoxy)bis(ethyl 4,4-dimethyl-3-oxopentanoato)titanium on patterned substrate

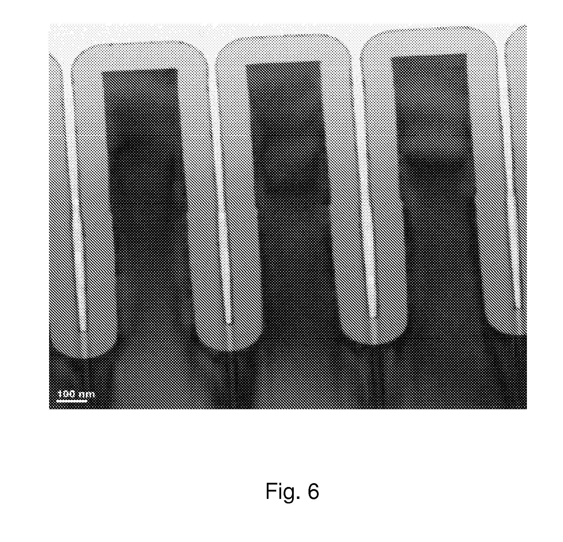

This example describes an ALD deposition of TiO₂ using bis(ethoxy)bis(ethyl 4,4-dimethyl-3-oxopentanoato)titanium and ozone on a trench pattern wafer with a spacing of around 550Å (55 nm), an aspect ratio of 20 to 1, and silicon nitride on the surface. The deposition temperature was 375°C. The deposition chamber pressure was around 1.0 Torr (133 Pa). The container for bis(ethoxy)bis(ethyl 4,4-dimethyl-3-oxopentanoato)titanium was kept at 150°C. The ALD conditions: Ti precursor pulse time was 15 seconds, the Ar purge time after Ti precursor pulse was 20 seconds, the ozone pulse time was 5 seconds, and the Ar purge time after ozone pulse was 10 seconds. The cycle was repeated 200 times. Figure 6 shows the Transmission Electron Microscope (TEM) image of the deposited TiO₂ film with a thickness of 8.9±0.5 nm at the top of the trenches, 8.8±0.5 nm at the top corner of the trenches, 8.7±0.5 nm at middle of the trenches, and 8.2±0.5 nm at the bottom of the trenches, demonstrating excellent step coverage (>90 %) from the top to the bottom of the patterned substrate.

## Claims

1. A method for deposition of a metal containing film under atomic layer deposition conditions onto a substrate, wherein the metal comprises at least one selected from the group consisting of titanium, hafnium and zirconium, said method comprising contacting the substrate with a composition having the formula: 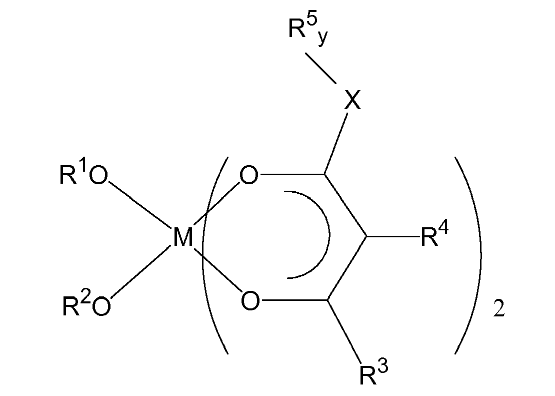 wherein M is a Group 4 metal selected from the group consisting of Ti, Zr, and Hf; wherein R¹ and R² are independently selected from the group consisting of linear or branched C₁₋₁₀ alkyls and C₆₋₁₂ aryls; R³ is selected from the group consisting of linear or branched C₁₋₁₀ alkyls and C₆₋₁₂ aryls; R⁴ is selected from the group consisting of hydrogen, C₁₋₁₀ alkyls and C₆₋₁₂ aryls; R⁵ is selected from the group consisting of linear or branched C₁₋₁₀ alkyls and C₆₋₁₂ aryls; and X = O or N,
wherein when X = O, y = 1, and R^{1,2 and 5} are the same, and when X = N, y = 2 and each R⁵ can be the same or different.

2. A method as claimed in Claim 1, wherein the composition is in a solvent selected from the group consisting of pentane; hexane; heptane; octane; decane; dodecane; ethylcyclohexane; propylcyclohexane; benzene; toluene; ethylbenzene; xylene; mesitylene; ethyl toluene; ethers; esters; nitriles; alcohols; amines including triethylamine and tert-butylamine; imines; carbodiimides including N,N'-diisopropylcarbodiimide; ketones; aldehydes; amidines; guanadines; isoureas; glyme having from 1 to 20 ethoxy -(C₂H₄O)-repeat units including dimethoxyethane, 1,2 -diethoxyethane and diglyme; organic ethers including propylene glycol, and dipropylene glycol dimethyl ether; C₂-C₁₂ alkanols; organic ethers; dialkyl ethers comprising C₁-C₆ alkyl moieties; C₄-C₈ cyclic ethers; tetrahydrofuran and dioxane; C₁₂-C₆₀ crown O₄-O₂₀ ethers; C₆-C₁₂ aliphatic hydrocarbons; C₆-C₁₈ aromatic hydrocarbons; organic esters; organic amines; polyamines; aminoethers; organic amides including organic amides in the form RCONR'R" wherein R and R' are alkyl having from 1-10 carbon atoms and they can be connected to form a cyclic group via (CH₂)ₙ, wherein n is from 4-6, and R" is selected from alkyl having from 1 to 4 carbon atoms, cycloalkyl, including N-methyl- or N-ethyl- or N-cyclohexyl-2-pyrrolidinones, *N*,*N*-Diethylacetamide, and *N*,*N-*Diethylformamide.

3. A method as claimed in Claim 1 or Claim 2, wherein said metal containing film is at least one multi-component metal oxide.

4. A method as claimed in Claim 3, wherein, when X=O, the at least one multi-component metal oxide is selected from the group consisting of strontium titanate, barium strontium titanate, and barium titanate and, when X=N, the at least one multi-component metal oxide is selected from strontium titanate, barium strontium titanate, barium titanate, titanium oxide doped with lanthanide, zirconium oxide doped with lanthanide, and hafnium oxide doped with lanthanide.

5. A method as claimed in any of the preceding claims, wherein the composition is a neat liquid.

6. method as claimed in any of Claim 1 to 4, wherein the composition is a solution consisting of Group 4 metal composition of Formula I and a solvent.

7. A method as claimed in Claim 6, wherein the solvent is selected from the group consisting of octane, ethylcyclohexane, dodecane, toluene, xylene, mesitylene, diethylbezene, and mixture thereof.

8. A method as claimed in any of the preceding claims, further comprising the steps of:
(a) introducing the composition in a vapor state into a reaction chamber and chemisorbing the composition onto a substrate which is heated; (b) purging away unreacted composition;
(c) introducing an oxygen source onto the heated substrate to react with the sorbed composition; and (d) purging away the unreacted oxygen source and reaction by-products.

9. A method as claimed in Claim 8, wherein steps (a) through (d) are repeated until a desired film depth is achieved.

10. A method as claimed in Claim 8 and Claim 9, wherein the composition is in a solvent, and wherein the vapors of the composition in the solvent are delivered via injection into a vaporizer.
